Europäisches Patentamt

European Patent Office

Office européen des brevets

(11) Publication number: **0 151 408**
**B1**

# EUROPEAN PATENT SPECIFICATION

(45) Date of publication of patent specification: **16.05.90**

(51) Int. Cl.⁵: **G 03 F 7/26**

(21) Application number: **85100407.7**

(22) Date of filing: **17.01.85**

(54) **A method of forming a patterned resist mask for etching via holes in an insulating layer.**

(30) Priority: **06.02.84 US 576991**

(43) Date of publication of application:
**14.08.85 Bulletin 85/33**

(45) Publication of the grant of the patent:
**16.05.90 Bulletin 90/20**

(84) Designated Contracting States:
**DE FR GB**

(56) References cited:
**US-A- 883 005**

**IBM TECHNICAL DISCLOSURE BULLETIN, vol. 19, no. 3, August 1976, page 859, New York, US; C. JOHNSON et al.: "Single coat photoresist lift-off structure**

**PATENTS ABSTRACTS OF JAPAN, vol. 2, no. 156, page 9918 E 78, 25th December 1978; & JP-A-53 122 427 (HITACH SEISAKUSHO K.K.) 25-10-1978**

(73) Proprietor: **International Business Machines Corporation**
**Old Orchard Road**
**Armonk, N.Y. 10504 (US)**

(72) Inventor: **Liu, Cheng-Yih**
**1287 Chateau Drive**
**San Jose California 95120 (US)**

(74) Representative: **Hobbs, Francis John**
**IBM United Kingdom Limited Intellectual Property Department Hursley Park Winchester Hampshire SO21 2JN (GB)**

(56) References cited:
**PATENTS ABSTRACTS OF JAPAN, vol. 9, no. 105 (P-534)1828r, 9th May 1985; & JP-A-59 228 648 (SUMITOMO DENKI KOGYO K.K.) 22-12-1984**

Courier Press, Leamington Spa, England.

## Description

This invention relates to a method for forming a patterned resist mask for etching via holes in an insulating layer.

Many microimaging processes such as, for example, those used in integrated circuit fabrication require high temperatures. However, the upper limit of the processing temperature is often restricted by the resist masking material properties. The deformation of the resist image during high temperature baking (and especially for temperatures greater than about 130°C.) also places a constraint on the minimum image size of the resist mask pattern and hence the product geometry. Organic polymer resist image layers are usually baked after development in order to improve resist adhesion and the physical properties of the resist. Baking is necessary so that the resist will withstand the chemicals used to etch the subtrate and/or a high temperature treatment such as metal deposition, without separating from the substrate or being subject to image distorting flow.

The problem of flow is particularly important in microimaging processes used in integrated circuit manufacture where dimensions are becoming smaller as the technology advances and very fine lines must be preserved. The resist layer is baked to at least a temperature to which it is expected to be subjected during substrate processing. The baking process is itself limited to times and temperatures where image distortion due to flow is minimized. Where the permissible baking conditions are insufficient to provide the needed resist properties, then an alternative technique of improving resist stability must be used.

Previous techniques for improving resist image stability after development have included bombardment of the resist image by placing the image bearing substrate in a glow discharge on an electrode in a barrel reactor with an inert gas atmosphere such as argon, nitrogen, or mixtures of nitrogen and hydrogen as described in, for example, Defensive Publication No. T883,005, dated Feb. 2, 1971. Treatment of developed resist images in a glow discharge with oxygen is described for example in US—A—3,816,196 and US—A—3,920,483. Where the resist image bearing substrates are placed in a plasma on an electrode such as, for example in the process described in T883,005 and subjected to ion bombardment, by choosing the correct conditions, stability of the resist layers to high temperatures can be achieved. However, in an electrodeless plasma treatment with oxygen or an inert gas, it has been found that resist image stability to temperatures of only up to about 210°C. can be provided.

US—A—4,187,331 discloses that a short electrodeless glow discharge treatment of 15 to 30 seconds using a fluorine containing atmosphere permits the heating or baking of the resist layer to temperatures of at least about 330°C. to thereby provide resist image stability during processing at very high temperatures. This process as well as the others described in the prior documents mentioned above form a stabilized or hardened layer on the upper part of the resist layer. This hardened layer is undesirable when etching via holes where sharp quartz edges at the top are to be avoided and good metal coverage is desired.

The aforementioned US—A—4,187,331 also described an electrodeless glow discharge treatment of about 2 minutes that converts the hardened surface layer of the resist which is formed after 15 to 30 seconds into a layer that the developer is more soluble in. Such a treatment yields a rounding of the resist image profile which is desirable for etching via holes in quartz. This treatment, however, has some drawbacks. One problem is the lack of adhesion. The heating effect caused by the long treatment time causes reflow of the photoresist and this results in more shrinkage and smaller vias. This treatment is difficult to control in order to obtain vias having a diameter in the range of 1 to 2 microns.

IBM Technical Disclosure Bulletin, volume 19, No. 3, August 1976, page 859 discloses a method of forming a patterned resist mask wherein the resist layer is subjected to an oxygen plasma before it is exposed and developed.

This invention seeks to provide a method of forming a patterned mask having via holes, of the order of one micron in size, with rounded sidewalls.

According to the invention, we provide a method of forming a patterned resist mask for etching via holes in an insulating layer, the method comprising exposing a positive resist layer to a pattern of radiation defining the positions of via holes, developing the resist layer in a developer solution to form the patterned mask the resist layer being subjected before it is developed to a gas plasma, the method being characterised in that the plasma is a gas containing nitrogen and hydrogen and in that after the plasma treatment and before the development the surface of the resist layer is bombarded with ions and electrons in a high voltage biased environment in which the resist layer is capacitively coupled for such a time that the solubility of an upper portion of the resist layer in the developer solution is increased.

The invention will now be explained with reference to the accompanying drawings, in which:-

Figures 1A, 1B and 1C represent cross-sections of resist masks containing via holes, produced by three known methods; and

Figure 2 represents a cross-section of an exposed and developed polymer resist layer which has been treated by a process according to the invention.

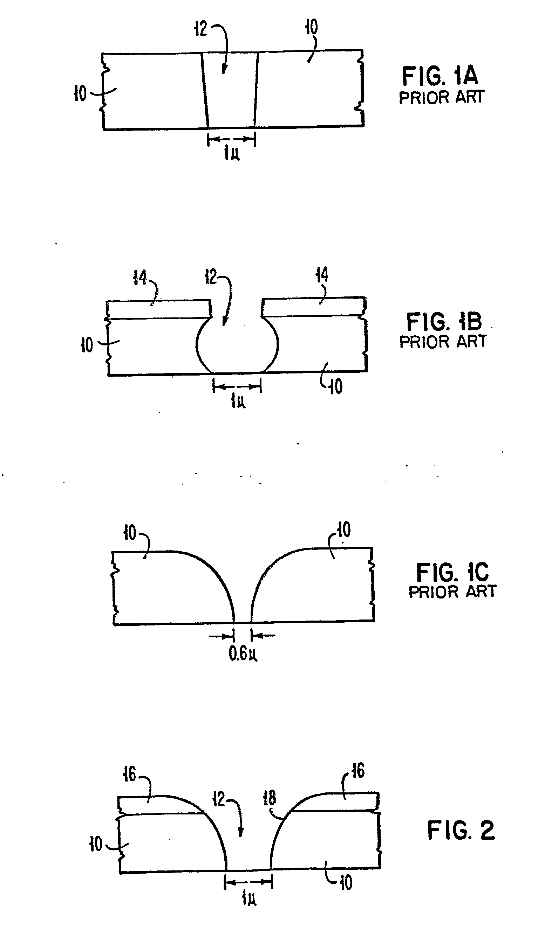

With reference to Figure 1A, a known patterned mask has a via hole 12 formed by exposure, development and subsequent baking of a resist layer 10.

Turning to Figure 1B, another known patterned mask has a via hole 12 formed in a polymer resist layer 10 which has been subjected to a short (15 to 30 seconds) electrodeless glow discharge treatment in a low pressure fluorine containing atmosphere, and then baked. This treatment results in the resist layer 10 having a hardened surface layer 14.

The polymer resist layer 10 shown in Figure 1C has been subjected to a relatively long (2 minutes) electrodeless glow discharge treatment in a low pressure fluorine containing atmosphere, and then baked.

There now follows a description, by way of example, of how the invention can be carried out.

A layer 10 (Figure 2) of an organic positive photoresist is formed on an insulating layer (not shown), for example $SiO_2$, in which via holes are to be etched. Examples of an organic positive photoresist which is preferred in the practice of this invention is the AZ type of photoresist (AZ is a trade mark of Shipley Company, Inc.). Alternatively, virtually any other positive photoresist could be used.

The photoresist layer is then exposed to a forming gas, that is, a gas containing nitrogen and hydrogen. The forming gas plasma is introduced into a parallel plate reactor with a gas flow of, for example, $NH_3^+$, $H^+$, $N^+$, $NH_3°$, $H°$, $N°$ and $e^-$ to provide a partial pressure of the order of 6.6 to 66 Pascals (0.05 to 0.5 Torr). The next step is to bombard the surface of the photoresist layer with ions and electrons in the parallel plate reactor to provide a high voltage bias environment. This step capacitively couples the photoresist layer that is positioned on the insulative substrate (not shown). Bombarding the surface of the photoresist layer forms a layer 16 that has increased solubility in the developer solution. The bombarding step is carried out for between 10 and 60 seconds with a preferred time being between 15 and 25 seconds. The longer the exposure time the thicker the layer 16 is. Exposure times of the order of 15 to 25 seconds provide a via hole 12 having a sounded sidewall profile 18 after the subsequent development step. Bombarding the photoresist layer for times longer than 60 seconds results in the photoresist layer having poor adhesion and too deep penetration.

The photoresist layer is exposed to UV light. The UV light exposure step may be before the forming gas plasma treatment or alternatively the photoresist may be exposed to UV light after the forming gas plasma treatment. It is exposed to the UV light for a period of about 0.2 to 20 seconds depending on the intensity of the exposure tool.

Examples of commercially available parallel plate reactors suitable for practising the invention are the IPC parallel plate System and LFE 1002. These parallel plate reactors use a voltage of between 50 to 2000 volts with a preferred range of 300 to 400 volts to create a highly biased electric field.

In a parallel plate reactor the photoresist layer and the substrate are capacitively coupled. The high voltage bias provides directionality. As a result of the high voltage bias field the ions and electrons impinge onto the surface of the photoresist.

Forming via holes having a rounded sidewall profile in accordance with this invention is desirable for via holes of approximately one mircron size.

## Claims

1. A method of forming a patterned resist mask for etching via holes in an insulating layer, the method comprising exposing a positive resist layer to a pattern of radiation defining the positions of via holes, developing the resist layer in a developer solution to form the patterned mask, the resist layer being subjected before it is developed to a gas plasma, the method being characterised in that the plasma is a gas containing nitrogen and hydrogen and in that after the plasma treatment and before the development the surface of the resist layer is bombarded with ions and electrons in a high voltage biased environment in which the resist layer is capacitively coupled for such a time that the solubility of an upper portion of the resist layer in the developer solution is increased.

2. A method as claimed in claim 1, in which the resist layer is exposed to a pattern of ultraviolet light before it is subjected to the plasma treatment.

3. A method as claimed in claim 1, in which the resist layer is exposed to a pattern of ultraviolet light after it is subjected to the plasma treatment.

4. A method as claimed in any preceding claim, in which the positive resist is of the AZ-type.

5. A method as claimed in any preceding claims, in which the resist layer is exposed to the ion and electron bombardment for 10 to 60 seconds.

6. A method as claimed in claim 5, in which the resist layer is exposed to the ion and electron bombardment for 15 to 25 seconds.

7. A method as claimed in any preceding claim, in which the voltage of the environment is 50 to 2000 volts.

8. A method as claimed in claim 7 in which the voltage of the environment is 300 to 400 volts.

## Patentansprüche

1. Verfahren der Bildung einer beständigen Maske mit Muster zum Ätzen von Durchgangslöchern in einer Isolierschicht, die Belichtung einer positiven beständigen Schicht mit einem Strahlenmuster enthaltend, das die Positionen der Durchgangslöcher bestimmt, mit anschließender Entwicklung der beständigen Schicht in einer Entwicklerlösung, um die Mustermaske zu bilden, wobei die beständige Schicht vor der Entwicklung einem Gasplasma ausgesetzt ist, Verfahren dadurch gekennzeichnet, daß das Plasma ein Gas ist, das Stickstoff und Wasserstoff enthält, und dadurch, daß nach der Behandlung mit Plasma und vor der Entwicklung die Oberfläche der beständigen Schicht mit Ionen und Elektronen in einer Umgebung mit hoher Vorspannung ausgesetzt wird, in der die beständige Schicht so lange kapazitiv gekoppelt wird, daß die Löslichkeit eines oberen Teils der beständigen Schicht in der Entwicklerlösung erhöht wird.

2. Verfahren gemäß Anspruch 1, in dem die beständige Schicht einem Muster ultravioletten Lichtes ausgesetzt wird, bevor sie der Plasmabehandlung unterzogen wird.

3. Verfahren gemäß Anspruch 1, in dem die beständige Schicht einem Muster ultravioletten Lichtes ausgesetzt wird, nachdem sie der Plasmabehandlung unterzogen wird.

4. Verfahren gemäß einem der vorangehenden Ansprüche, in dem die positive Beständigkeit vom AZ-Typ ist.

5. Verfahren gemäß einem der vorangehenden Ansprüche, in dem die beständige Schicht 10 bis 60 Sekunden lang mit Ionen und Elektronen beschossen wird.

6. Verfahren gemäß Anspruch 5, in dem die beständige Schicht 15 bis 25 Sekunden lang mit Ionen und Elektronen beschossen wird.

7. Verfahren gemäß einem der vorangehenden Ansprüche, in dem die Umgebungsspannung 50 bis 2000 Volt beträgt.

8. Verfahren gemäß Anspruch 7, in dem die Umgebungsspannung 300 bis 400 Volt beträgt.

## Revendications

1. Procédé pour former un masque de réserve selon un motif pour la gravure de trous de passage dans une couche isolante, comprenant l'exposition d'une couche de réserve positive à un motif de rayonnement définissant les positions des trous de passage le développement de la couche de réserve dans une solution de révélateur pour former le masque déterminant un motif, la couche de réserve étant soumise à un plasma de gaz avant d'être développée, caractérisé en ce que le plasma est un gaz contenant de l'azote et de l'hydrogène et qu'après le traitement par plasma et avant le développement, la surface de la couche de réserve est bombardée avec des ions et des électrons dans un environnement polarisé à haute tension dans lequel la couche de réserve est couplée de façon capacitive pendant une période de temps telle que la solubilité d'une partie supérieure de la couche de réserve devient plus grande dans la solution de révélateur.

2. Procédé suivant la revendication 1, caractérisé en ce que la couche de réserve est exposée à une motif de lumière ultraviolette avant d'être soumise au traitement par un plasma.

3. Procédé suivant la revendication 1, caractérisé en ce que la couche de réserve est exposée à un motif de lumière ultraviolette après avoir été soumise au traitement par un plasma.

4. Procédé suivant l'une quelconque des revendications précédentes, caractérisé en ce que la réserve positive est du type AZ.

5. Procédé suivant l'une quelconque des revendications précéentes, caractérisé en ce que la couche de réserve est exposée au bombardement ionique ou électronique pendant 10 à 60 secondes.

6. Procédé suivant la revendication 5, caractérisé en ce que la couche de réserve est exposée au bombardement ionique ou électronique pendant 15 à 25 secondes.

7. Procédé suivant l'une quelconque des revendications précédentes, caractérisé en ce que la tension de l'environnement est de 50 à 2000 volts.

8. Procédé suivant la revendication 7, caractérisé en ce que la tension de l'environnement est de 300 à 400 volts.

FIG. 1A
PRIOR ART

FIG. 1B
PRIOR ART

FIG. 1C
PRIOR ART

FIG. 2

1